# EUROPEAN PATENT SPECIFICATION

(11) **EP 3 931 965 B1**
(45) Date of publication and mention of the grant of the patent: **02.12.2026**
(21) Application number: 20757696.8
(22) Date of filing: 04.02.2020
(51) Int. Cl.: H03K 19/195, H03M 1/12

(54) **JOSEPHSON ANALOG-TO-DIGITAL CONVERTER SYSTEM**
JOSEPHSON-ANALOG/DIGITAL-UMSETZERSYSTEM
SYSTÈME DE CONVERTISSEUR ANALOGIQUE-NUMÉRIQUE DE JOSEPHSON

(30) Priority: 01.03.2019 US 201916290373
(43) Date of publication of application: 05.01.2022
(73) Proprietor: Northrop Grumman Systems Corporation, Falls Church, VA 22042-4511 (US)
(72) Inventor: STOUTIMORE, Micah John Atman, Kensington, Maryland 20895 (US); MANNING, Timothy Andrew, Silver Spring, Maryland 20901 (US); NOWAKOWSKI, Mark Edward, Millersville, Maryland 21108 (US); MARAKOV, Alexander, Columbia, Maryland 21045 (US)
(74) Representative: Marks & Clerk LLP
(86) International application number: PCT/US2020/016622
(87) International publication number: WO 2020/219142

(56) References cited:
- EP-A2- 0 660 126
- GUPTA D ET AL: "Superconductor Analog-to-Digital Converters", PROCEEDINGS OF THE IEEE, IEEE. NEW YORK, US, vol. 92, no. 10, 1 October 2004 (2004-10-01), pages 1564 - 1584, XP011118881, ISSN: 0018-9219, DOI: 10.1109/JPROC.2004.833660

## Description

### RELATED APPLICATIONS

This application claims priority from U.S. Patent Application Serial No. 16/290373, filed 1 March 2019.

### GOVERNMENT INTEREST

The invention was made under Government Contract. Therefore, the US Government has rights to the invention as specified in that contract.

### TECHNICAL FIELD

This disclosure relates generally to computing systems, and more specifically to a Josephson analog-to-digital converter system.

### BACKGROUND

Analog-to-digital converters (ADCs) are crucial components for computing technologies to implement logic functions. For example, ADCs are essential for both semiconductor-based and superconducting-based technology applications (computation, radar, sensors, communications, etc.) to convert analog information to digital information for processing. In many applications, the properties of ADCs can limit the overall device performance. As an example, superconducting ADCs can be especially attractive since their sensitivity and responsiveness metrics can be limited solely by fundamental constants and the magnetic flux response of associated Josephson junctions.

EP0660126 A2 describes a Josephson signal detector having a sensor with at least one Josephson junction (e.g., a SQUID) and a comparator (e.g., an analog-to-digital converter); a measurement system using such detector; and a method of using such detector and measurement system.

Gupta D et al "Superconductor Analog-to-Digital Converters", Proceedings of the IEEE, IEEE. New York, US, vol. 92, no. 10, 1 October 2004, pages 1564-1584 reviews designs, test results, and future development trends of superconductor analog-to-digital converters (ADCs).

### SUMMARY

The invention is defined by the independent claims. Embodiment are described by the dependent claims.
One example includes a Josephson analog-to-digital converter (ADC) system. The system includes a control line inductively coupled to an input signal line on which an input analog signal is provided. The input signal line can be inductively coupled to the control line to propagate an induced input current that is based on the input analog signal on the control line.
The system also includes at least one Josephson transmission line (JTL) stage that is biased via a DC bias current and is configured to generate an output pulse in response to the induced input current and the DC bias current exceeding a predetermined threshold current associated with the at least one JTL stage.

Another example includes a method for converting an analog input signal to an output pulse. The method includes providing the analog signal on an input signal line to inductively provide an induced input current on a control line. The method also includes providing a DC tuning current on a DC bias line to inductively provide a DC bias current on the control line. The method further includes providing a clock signal to at least one JTL stage that is coupled to the control line to generate the output pulse on an output from the at least one JTL stage at a predetermined phase of the clock signal in response to the induced input current and the DC bias current exceeding a predetermined threshold current associated with the at least one JTL stage.

Another example includes a Josephson ADC system. The system includes a control line inductively coupled to an input signal line on which an input analog signal is provided. The input signal line can be inductively coupled to the control line to propagate an induced input current that is based on the input analog signal on the control line. The system also includes a first JTL stage that is coupled to the control line and is biased via an induced DC bias current. The system further includes a second JTL stage that interconnects the control line and an output and which is configured to provide an output pulse on the output in response to the induced input current and the DC bias current exceeding a predetermined threshold current associated with the first and second JTL stages.

### BRIEF DESCRIPTION OF THE DRAWINGS

FIG. 1 illustrates an example of a Josephson ADC system.
FIG. 2 illustrates an example circuit diagram of a Josephson ADC system.
FIG. 3 illustrates an example of a method for converting an analog input signal to an output pulse.

### DETAILED DESCRIPTION

This disclosure relates generally to computing systems, and more specifically to a Josephson analog-to-digital converter (ADC) system. The Josephson ADC system can include a control line that is inductively coupled to an input signal line on which an input analog signal is provided. The input analog signal can be a current that corresponds to an analog signal to which a corresponding output pulse is provided at an output of the Josephson ADC system. For example, the output pulse can correspond to a single flux quantum (SFQ) pulse that is provided in response to the analog input signal having an amplitude that exceeds a predetermined threshold. The analog input signal can thus inductively provide an induced input current on the control line, such as via a transformer.

The control line can be coupled to at least one Josephson transmission line (JTL) stage that is configured to provide the output pulse in response to the analog input signal. For example, a DC tuning current can be provided via a DC bias line to inductively provide a DC bias current on the control line. Therefore, in response to the induced input current and the DC bias current exceeding a predetermined current threshold, the JTL stage(s) can provide the output pulse on an output. For example, the control line can interconnect a pair of substantially identical JTL stages that are coupled to a clock line that provides a clock signal (e.g., a reciprocal quantum logic (RQL) clock signal). Therefore, the JTL stages can balance the clock signal based on destructive interference, as described in greater detail herein, and can bias the JTL stages to provide the output pulse at a predetermined phase of the clock signal. Therefore, the Josephson ADC system can operate in a superconducting computer environment to provide a digital output pulse in response to an analog signal.

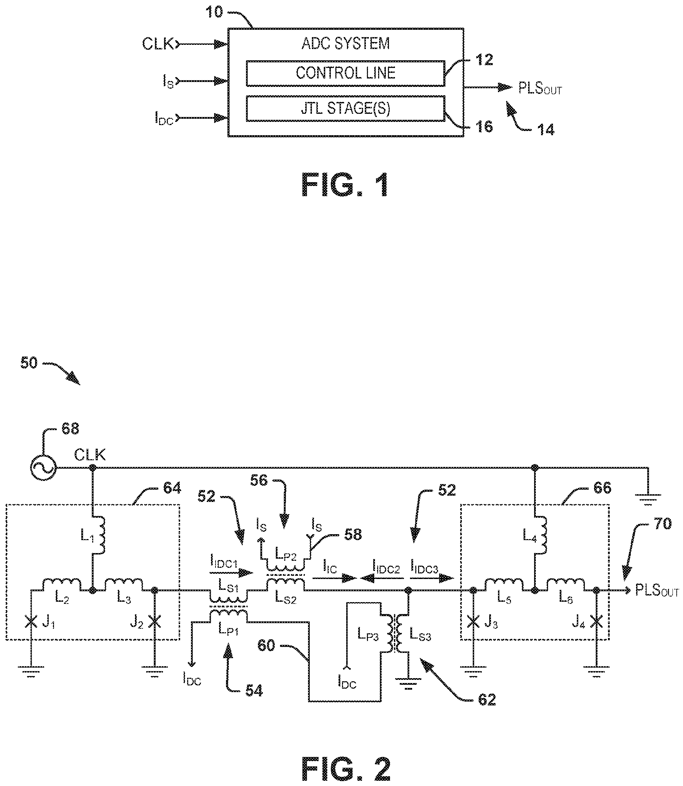

FIG. 1 illustrates an example of a Josephson ADC system 10. The Josephson ADC system 10 can correspond to an ADC that can be implemented in any of a variety of computer applications for converting an analog signal to a digital representation. For example, the Josephson ADC system 10 can be implemented in a superconducting and/or classical computing environment to provide analog-to-digital conversion.

The Josephson ADC system 10 includes a control line 12 that can be arranged as a signal conductor, such as including one or more inductors that can correspond to secondary windings of respective transformers that is inductively coupled to an input signal line on which an input analog signal I_{S} is provided. The input analog signal I_{S} can be a current that corresponds to an analog signal to which a corresponding output pulse, demonstrated in the example of FIG. 1 as a signal "PLS_{OUT}", is provided at an output 14 of the Josephson ADC system 10. For example, the output pulse PLS_{OUT} can correspond to a single flux quantum (SFQ) pulse that is provided in response to the analog input signal I_{S} having an amplitude that exceeds a predetermined threshold. The analog input signal I_{S} can thus inductively provide an induced input current on the control line 12, such as via a transformer.

The control line 12 can be coupled to at least one Josephson transmission line (JTL) stage 16 that is configured to provide the output pulse PLS_{OUT} in response to the analog input signal I_{S}. In the example of FIG. 1, a DC tuning current I_{DC} is also demonstrated as provided to the control line 12, such as via a DC bias line, to inductively provide a DC bias current on the control line 12. Therefore, in response to the induced input current and the DC bias current exceeding a predetermined current threshold, the JTL stage(s) 16 can provide the output pulse PLS_{OUT} on the output 14. Additionally, in the example of FIG. 1, a clock signal CLK is provided to the Josephson ADC system 10, such that the clock signal CLK can be coupled to the JTL stage(s) 16. Therefore, the JTL stage(s) can be biased by the clock signal CLK in addition to the DC bias current provided via the DC tuning current I_{DC} to provide the output pulse PLS_{OUT} at a predetermined phase of the clock signal CLK. For example, the clock signal CLK can be a reciprocal quantum logic (RQL) clock signal that is implemented in RQL circuits. Therefore, the Josephson ADC system 10 can operate in a superconducting computer environment to provide a digital output pulse (e.g., the output pulse PLS_{OUT}), in response to an analog signal (e.g., the analog input signal I_{S}).

FIG. 2 illustrates an example circuit diagram of a Josephson ADC system 50. The Josephson ADC system 50 can correspond to the Josephson ADC system 10 in the example of FIG. 1. For example, the Josephson ADC system 50 can be implemented in a superconducting and/or classical computing environment to provide analog-to-digital conversion. Therefore, reference is to be made to the example of FIG. 1 in the following description of the example of FIG. 2.

The Josephson ADC system 50 includes a control line 52 that is demonstrated as a signal conductor. In the example of FIG. 2, the Josephson ADC system 50 includes a first transformer 54 that includes a primary winding L_{P1} and a secondary winding L_{S1}, and also includes a second transformer 56 that includes a primary winding L_{P2} and a secondary winding L_{S2}. The primary winding L_{P1} is coupled to a DC bias line 60 that is configured to conduct a DC tuning current I_{DC}, such that the secondary winding L_{S1} is configured to generate a first induced DC bias current I_{IDC1} that is proportional to the DC tuning current I_{DC}. The primary winding L_{P2} is coupled to an input signal line 58 that is configured to conduct an analog input signal I_{S}, such that the secondary winding L_{S2} is configured to generate an induced input current I_{IC} corresponding to the analog input signal I_{S}. The secondary windings L_{S1} and L_{S2} are arranged in series with respect to each other on the control line 52.

Additionally, the Josephson ADC system 50 includes a third transformer 62 that includes a primary winding L_{P3} and a secondary winding L_{S3}. The primary winding L_{P3} is coupled to the DC bias line 60, and the secondary winding L_{S3} interconnects the control line 52 and a low-voltage rail (e.g., ground). Therefore, secondary winding L_{S3} generates an induced current that is a sum of a second induced DC bias current I_{IDC2} and a third induced DC bias current I_{IDC3} that propagate in opposite directions on the control line 52. As an example, the inductive coupling of the first and third transformers 54 and 62 can be different, such that the first induced DC bias current I_{IDC1} and the sum of the second and third induced DC bias currents I_{IDC2} and I_{IDC3} can be unequal, as described in greater detail herein.

The Josephson ADC system 52 also includes a first JTL stage 64 and a second JTL stage 66 that are arranged on opposite respective ends of the control line 52. The first JTL stage 64 includes an inductor L₁ that provides a clock signal CLK from a clock source 68. As an example, the clock signal CLK can correspond to an RQL clock signal, such that as provided in an RQL circuit, and can thus be aligned with a predetermined phase of the RQL clock signal. The first JTL stage 64 also includes an inductor L₂ that is coupled to a Josephson junction J₁ that interconnects the inductor L₂ and the low-voltage rail. The first JTL stage 64 further includes an inductor L₃ that is coupled to the control line 52 and a Josephson junction J₂ that interconnects the control line 52 and the low-voltage rail. The first JTL stage 64 is thus arranged as a superconducting quantum interference device (SQUID) that receives the clock signal CLK.

The second JTL stage 66 includes an inductor L₄ that provides the clock signal CLK from the clock source 68. The second JTL stage 66 also includes an inductor L₅ that is coupled to the control line 52 and a Josephson junction J₃ that interconnects the control line 52 and the low-voltage rail. The second JTL stage 66 further includes an inductor L₆ that is coupled to an output 70 and to a Josephson junction J₄ that interconnects the inductor L₆ and the low-voltage rail. As described herein, the output 70 provides an output pulse PLS_{OUT} in response to the analog input signal I_{S}. As an example, the output pulse PLS_{OUT} can be provided as an SFQ pulse, such as provided along a Josephson transmission line (not shown) to further downstream superconducting circuit(s). The second JTL stage 66 is thus arranged as a SQUID that receives the clock signal CLK, similar to the first JTL stage 64. Additionally, the Josephson junctions J₂ and J₃ between the control line 52 likewise form a SQUID, such that the JTL stages 64 and 66 cooperate to trigger in response to the analog input signal I_{S} achieving a predetermined threshold amplitude, as described herein.

As an example, the first and second JTL stages 64 and 66 can be arranged substantially identically with respect to the components arranged therein. The substantially identical arrangement of the JTL stages 64 and 66 can also provide balance for the Josephson ADC system 50, such as with respect to the clock signal CLK. For example, because the clock signal CLK is provided to both of the JTL stages 64 and 66 at the same phase, the clock signal CLK is provided through each of the inductors L₃ and L₅ to destructively combine at the control line 52. Therefore, the amplitude of the clock signal CLK does not interfere with the amplitude of the analog input signal I_{S}, or the induced input current I_{IC} that is provided from the secondary winding L_{S2}.

The JTL stages 64 and 66 are configured to cooperatively provide the output pulse PLS_{OUT} at the output 70 in response to an amplitude of the analog input signal I_{S} being greater than a predetermined threshold. For example, the DC tuning current I_{DC} can be set to a predetermined amplitude to bias the Josephson junctions J₁, J₂, J₃, and J₄, such that, in response to a sum of the analog input signal I_{S} and the DC tuning current I_{DC} being greater than a predetermined amplitude, the Josephson junctions J₁, J₂, J₃, and J₄ can trigger to provide the output pulse PLS_{OUT} at the output 70, such as at a predetermined phase of the clock signal CLK (e.g., based on a further bias of the Josephson junctions J₁, J₂, J₃, and J₄ by the clock signal CLK).

As described previously, the inductive coupling of the first and third transformers 54 and 62 can be different, such that the first induced DC bias current I_{IDC1} and the sum of the second and third induced DC bias currents I_{IDC2} and I_{IDC3} can be unequal. For example, the third transformer 62 can have a substantially greater inductive coupling than the first transformer 54. As a result, the first and second induced DC bias currents I_{IDC1} and I_{IDC2} can have amplitudes that are approximately equal, such that the amplitudes of the first and second induced DC bias currents I_{IDC1} and I_{IDC2} cancel each other in the portion of the control line 52 on which the secondary winding L_{S2} of the second transformer 56 is provided. As a result, the induced DC current does not interfere with the analog input signal I_{S}, or the induced input current I_{IC} that is provided from the secondary winding L_{S2}.

For example, the third induced DC bias current I_{IDC3} can be configured to provide a bias to the Josephson junctions J₃ and J₄ in the second JTL stage 66. Therefore, the induced input current I_{IC} combines with the third induced DC bias current I_{IDC3}. In response to the sum of the induced input current I_{IC} and the third induced DC bias current I_{IDC3} (e.g., and the amplitude of the clock signal CLK at the corresponding predetermined phase) being greater than a critical current associated with the Josephson junction J₃, the Josephson junction J₃ can trigger to provide a fluxon. The fluxon can thus likewise cause the Josephson junction J₄ to trigger to provide the output pulse PLS_{OUT} at the output 70. Furthermore, based on the arrangement of the Josephson junctions J₂ and J₃ between the control line 52 to form a SQUID, the Josephson junctions J₁ and J₂ also trigger. As an example, the reflection of the triggering of the Josephson junction J₁ can also provide a reset of the Josephson junctions J₁, J₂, J₃, and J₄, such as at an opposite phase of the clock signal CLK. Alternatively, the Josephson junctions J₁, J₂, J₃, and J₄ can be reset by other means not demonstrated herein.

Therefore, as described herein, the Josephson ADC system 50 can operate in a superconducting computer environment to provide a digital output pulse (e.g., the output pulse PLS_{OUT}), in response to an analog signal (e.g., the analog input signal I_{S}). As described herein, the Josephson ADC system 50 can provide the analog-to-digital conversion in a manner that substantially mitigates noise associated with the tuning signal source (e.g., the DC tuning current I_{DC}) and the clock signal (e.g., the clock signal CLK) from affecting the analog input signal I_{S}. For example, as described previously, the Josephson ADC system 50 can be implemented in superconducting circuit environments in which the signal amplitudes can be very small. As a result, noise that can result from dominant signal sources, such as the DC tuning current I_{DC} and the clock signal CLK, can be mitigated in the conversion of the small amplitude analog input signal I_{S} to the small amplitude output pulse PLS_{OUT}. Accordingly, the Josephson ADC system 50 is demonstrated herein as a passive, robust, and application-independent method to convert low amplitude analog or digital electrical signals into discrete SFQ pulses, such as within an RQL architecture. As a result, for example, the Josephson ADC system 50 can provide a bridge between the RQL digital circuit logic family and a diverse array of signal sources (e.g., electrical signals produced by alternative superconducting logic families or analog signals generated from the readout of superconducting circuits).

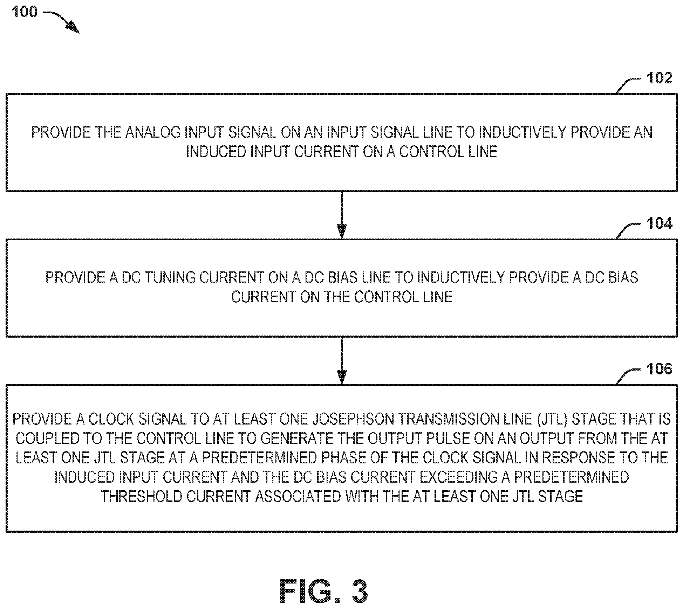

In view of the foregoing structural and functional features described above, a methodology in accordance with various aspects of the present invention will be better appreciated with reference to FIG. 3. While, for purposes of simplicity of explanation, the methodology of FIG. 3 is shown and described as executing serially, it is to be understood and appreciated that the present invention is not limited by the illustrated order, as some aspects could, in accordance with the present invention, occur in different orders and/or concurrently with other aspects from that shown and described herein. Moreover, not all illustrated features may be required to implement a methodology in accordance with an aspect of the present invention.

FIG. 3 illustrates an example of a method 100 for converting an analog input signal (e.g., the analog input signal I_{S}) to an output pulse (e.g., the output pulse PLSour). At 102, the analog input signal is provided on an input signal line (e.g., the input signal line 58) to inductively provide an induced input current on a control line (e.g., the control line 12). At 104, a DC tuning current (e.g., the DC tuning current I_{DC}) is provided on a DC bias line (e.g., the DC bias line 60) to inductively provide a DC bias current (e.g., the induced DC bias currents I_{IDC1}, I_{IDC2}, and I_{IDC3}) on the control line. At 106, a clock signal (e.g., the clock signal CLK) is provided to at least one Josephson transmission line (JTL) stage (e.g., the JTL stage(s) 16) that is coupled to the control line to generate the output pulse on an output (e.g., the output 14) from the at least one JTL stage at a predetermined phase of the clock signal in response to the induced input current and the DC bias current exceeding a predetermined threshold current associated with the at least one JTL stage.

## Claims

1. A Josephson analog-to-digital converter system (50) comprising:
a control line (52) inductively coupled to an input signal line (58) on which an input analog signal (I_{S}) is provided, the input signal line (58) being inductively coupled to the control line (52) to propagate an induced input current (I_{IC}) that is based on the input analog signal (I_{S}), on the control line (52);
at least one Josephson transmission line JTL stage (64, 66) that is biased via a DC bias current (I_{IDC1}, I_{IDC2}, I_{IDC3}) and is configured to generate at a predetermined phase of a clock signal provided to the JTL stage (64, 66) an output pulse in response to the induced input current (I_{C}) and the DC bias current (I_{IDC1}, I_{IDC2}, I_{IDC3}) exceeding a predetermined threshold current associated with the at least one JTL stage;
**characterised by** further comprising:
a DC bias line (60) inductively coupled to the control line (52), the DC bias line (60) configured to conduct a DC tuning current (I_{DC}) that inductively provides said DC bias current (I_{IDC1}, I_{IDC2}, I_{IDC3}) on the control line (52), the DC bias line (60) being inductively coupled to the control line via a first transformer (54) and a third transformer (62), the induced input current (I_{DC}) being provided via a second transformer (56) arranged on the control line (52) between the first and third transformers (54, 62).

2. The system of claim 1, wherein the induced DC bias current has approximately zero amplitude at a secondary winding of the second transformer.

3. The system of claim 2, wherein the first transformer comprises a first primary winding configured to propagate the DC tuning current and a first secondary winding configured to propagate a first portion of the DC bias current in a first direction on the control line, wherein the third transformer comprises a second primary winding configured to propagate the DC tuning current and a second secondary winding configured to propagate a second portion of the DC bias current in a second direction on the control line and a third portion of the DC bias current in the first direction on the control line, wherein the first portion and the second portion of the DC bias current are approximately equal.

4. The system of claim 2, wherein the first and third transformers are not equal with respect to the inductive coupling of the DC tuning current to provide the induced DC bias current to the control line.

5. The system of claim 1, wherein the at least one JTL stage comprises a first JTL stage and a second JTL stage that are arranged on opposite ends of the control line, wherein each of the JTL stages is arranged substantially the same.

6. The system of claim 5, wherein the first JTL stage comprises a first superconducting quantum interference device SQUID coupled to a clock signal and coupled to the control line,
wherein the second JTL stage comprises a second SQUID coupled to the clock signal and interconnecting the control line and an output (14) on which the output pulse is provided in response to the induced input current and the DC bias current exceeding the predetermined threshold current associated with the first and second JTL stages at a predetermined phase of the clock signal.

7. The system of claim 6, wherein the clock signal is a reciprocal quantum logic RQL clock signal.

8. The system of claim 5, wherein each of the first and second JTL stages are coupled to a clock signal, wherein the clock signal is configured to bias at least one Josephson junction associated with each of the first and second JTL stages at a respective phase of the clock signal and to destructively combine at the control line.

9. A method (100) for converting an analog input signal to an output pulse, the method comprising:
providing (102) the analog input signal on an input signal line to inductively provide an induced input current on a control line;
providing (104) a DC tuning current on a DC bias line that is inductively coupled to the control line via a first transformer and a third transformer to inductively provide a DC bias current on the control line, wherein the induced DC bias current is provided via a third transformer arranged on the control line between the first and second transformers; and
providing (106) a clock signal to at least one Josephson transmission line JTL stage that is coupled to the control line to generate the output pulse on an output from the at least one JTL stage at a predetermined phase of the clock signal in response to the induced input current and the DC bias current exceeding a predetermined threshold current associated with the at least one JTL stage.

10. The method of claim 9, wherein providing the DC tuning current further comprises inductively providing the induced DC bias current having a zero amplitude at a secondary winding of the second transformer.

11. The method of claim 9, wherein providing the clock signal comprises providing the clock signal as a reciprocal quantum logic RQL clock signal, wherein the at least one JTL stage comprises a first JTL stage and a second JTL stage that are arranged on opposite ends of the control line, wherein the first JTL stage comprises a first superconducting quantum interference device SQUID coupled to the RQL clock signal and coupled to the control line, wherein the second JTL stage comprises a second SQUID coupled to the RQL clock signal and interconnecting the control line and the output.

12. The method of claim 11, wherein providing the RQL clock signal comprises providing the RQL clock signal to each of the first and second JTL stages to bias at least one Josephson junction associated with each of the first and second JTL stages at a respective phase of the RQL clock signal and to destructively combine at the control line.

## Patentansprüche

1. Josephson-Analog-Digital-Wandlersystem (50), umfassend:
eine Steuerleitung (52), welche mit einer Eingangssignalleitung (58), auf welcher ein analoges Eingangssignal (I_{S}) bereitgestellt wird, induktiv gekoppelt ist, wobei die Eingangssignalleitung (58) mit der Steuerleitung (52) induktiv gekoppelt ist, um einen induzierten Eingangsstrom (I_{IC}), welcher auf dem analogen Eingangssignal (I_{S}) basiert, auf der Steuerleitung (52) zu propagieren;
zumindest eine Josephson-Übertragungsleitungs- JTL-Stufe (64, 66), welche über einen Gleichstromvorspannungsstrom (I_{IDC1}, I_{IDC2}, I_{IDC3}) vorgespannt ist und dazu konfiguriert ist, bei einer vorbestimmten Phase eines der JTL-Stufe (64, 66) bereitgestellten Taktsignals einen Ausgangsimpuls zu erzeugen, wenn der induzierte Eingangsstrom (I_{C}) und der Gleichstromvorspannungsstrom (I_{IDC1}, I_{IDC2}, I_{IDC3}) einen vorbestimmten Schwellenstrom überschreiten, welcher mit der zumindest einen JTL-Stufe verknüpft ist;
**dadurch gekennzeichnet, dass** es weiter umfasst:
eine Gleichstromvorspannungsleitung (60), welche mit der Steuerleitung (52) induktiv gekoppelt ist, wobei die Gleichstromvorspannungsleitung (60) dazu konfiguriert ist, einen Gleichstromabstimmstrom (I_{DC}) zu leiten, welcher den Gleichstromvorspannungsstrom (I_{IDC1}, I_{IDC2}, I_{IDC3}) auf der Steuerleitung (52) induktiv bereitstellt, wobei die Gleichstromvorspannungsleitung (60) über einen ersten Transformator (54) und einen dritten Transformator (62) mit der Steuerleitung induktiv gekoppelt ist, wobei der induzierte Eingangsstrom (I_{DC}) über einen zweiten Transformator (56) bereitgestellt wird, welcher auf der Steuerleitung (52) zwischen dem ersten und dritten Transformator (54, 62) angeordnet ist.

2. System nach Anspruch 1, wobei der induzierte Gleichstromvorspannungsstrom an einer Sekundärwicklung des zweiten Transformators eine Amplitude von annähernd Null aufweist.

3. System nach Anspruch 2, wobei der erste Transformator eine erste Primärwicklung, welche dazu konfiguriert ist, den Gleichstromabstimmstrom zu propagieren, und eine erste Sekundärwicklung umfasst, welche dazu konfiguriert ist, einen ersten Teil des Gleichstromvorspannungsstroms in einer ersten Richtung auf der Steuerleitung zu propagieren, wobei der dritte Transformator eine zweite Primärwicklung, welche dazu konfiguriert ist, den Gleichstromabstimmstrom zu propagieren, und eine zweite Sekundärwicklung umfasst, welche dazu konfiguriert ist, einen zweiten Teil des Gleichstromvorspannungsstroms in einer zweiten Richtung auf der Steuerleitung und einen dritten Teil des Gleichstromvorspannungsstroms in der ersten Richtung auf der Steuerleitung zu propagieren, wobei der erste Teil und der zweite Teil des Gleichstromvorspannungsstroms annähernd gleich sind.

4. System nach Anspruch 2, wobei der erste und dritte Transformator hinsichtlich der induktiven Kopplung des Gleichstromabstimmstroms zum Bereitstellen des induzierten Gleichstromvorspannungsstroms für die Steuerleitung nicht gleich sind.

5. System nach Anspruch 1, wobei die zumindest eine JTL-Stufe eine erste JTL-Stufe und eine zweite JTL-Stufe umfasst, welche an gegenüberliegenden Enden der Steuerleitung angeordnet sind, wobei jede der JTL-Stufen im Wesentlichen gleich angeordnet ist.

6. System nach Anspruch 5, wobei die erste JTL-Stufe eine erste supraleitende Quanteninterferenzvorrichtung SQUID umfasst, welche mit einem Taktsignal gekoppelt und mit der Steuerleitung gekoppelt ist, wobei die zweite JTL-Stufe eine zweite SQUID umfasst, welche mit dem Taktsignal gekoppelt ist und die Steuerleitung und einen Ausgang (14) miteinander verbindet, an welchem der Ausgangsimpuls bereitgestellt wird, wenn der induzierte Eingangsstrom und der Gleichstromvorspannungsstrom den vorbestimmten Schwellenstrom, welcher mit der ersten und zweiten JTL-Stufe verknüpft ist, bei einer vorbestimmten Phase des Taktsignals überschreitet.

7. System nach Anspruch 6, wobei das Taktsignal ein reziprokes Quantenlogik-RQL-Taktsignal ist.

8. System nach Anspruch 5, wobei jede der ersten und zweiten JTL-Stufe mit einem Taktsignal gekoppelt ist, wobei das Taktsignal dazu konfiguriert ist, zumindest einen Josephson-Kontakt, welcher mit jeder der ersten und zweiten JTL-Stufe verknüpft ist, in einer jeweiligen Phase des Taktsignals vorzuspannen und sich an der Steuerleitung destruktiv zu kombinieren.

9. Verfahren (100) zum Umwandeln eines analogen Eingangssignals in einen Ausgangsimpuls, wobei das Verfahren umfasst:
Bereitstellen (102) des analogen Eingangssignals auf einer Eingangssignalleitung, um einen induzierten Eingangsstrom auf einer Steuerleitung induktiv bereitzustellen;
Bereitstellen (104) eines Gleichstromabstimmstroms auf einer Gleichstromvorspannungsleitung, welche über einen ersten Transformator und einen dritten Transformator mit der Steuerleitung induktiv gekoppelt ist, um einen Gleichstromvorspannungsstrom auf der Steuerleitung induktiv bereitzustellen, wobei der induzierte Gleichstromvorspannungsstrom über einen dritten Transformator bereitgestellt wird, welcher auf der Steuerleitung zwischen dem ersten und zweiten Transformator angeordnet ist; und
Bereitstellen (106) eines Taktsignals für zumindest eine Josephson-Übertragungsleitungs- JTL-Stufe, welche mit der Steuerleitung gekoppelt ist, um den Ausgangsimpuls an einem Ausgang der zumindest einen JTL-Stufe in einer vorbestimmten Phase des Taktsignals zu erzeugen, wenn der induzierte Eingangsstrom und der Gleichstromvorspannungsstrom einen vorbestimmten Schwellenstrom überschreitet, welcher mit der zumindest einen JTL-Stufe verknüpft ist.

10. Verfahren nach Anspruch 9, wobei Bereitstellen des Gleichstromabstimmstroms weiter induktives Bereitstellen des induzierten Gleichstromvorspannungsstroms, der Amplitude Null aufweist, an einer Sekundärwicklung des zweiten Transformators umfasst.

11. Verfahren nach Anspruch 9, wobei Bereitstellen des Taktsignals Bereitstellen des Taktsignals als Reciprocal Quantum Logic RQL-Taktsignal umfasst, wobei die zumindest eine JTL-Stufe eine erste JTL-Stufe und eine zweite JTL-Stufe umfasst, welche an gegenüberliegenden Enden der Steuerleitung angeordnet sind, wobei die erste JTL-Stufe eine erste supraleitende Quanteninterferenzvorrichtung SQUID umfasst, welche mit dem RQL-Taktsignal gekoppelt und mit der Steuerleitung gekoppelt ist, wobei die zweite JTL-Stufe eine zweite SQUID umfasst, welche mit dem RQL-Taktsignal gekoppelt ist und die Steuerleitung und den Ausgang miteinander verbindet.

12. Verfahren nach Anspruch 11, wobei Bereitstellen des RQL-Taktsignals Bereitstellen des RQL-Taktsignals für jede der ersten und zweiten JTL-Stufen umfasst, um zumindest einen Josephson-Kontakt, welcher mit jeder der ersten und zweiten JTL-Stufe verknüpft ist, in einer jeweiligen Phase des RQL-Taktsignals vorzuspannen und an der Steuerleitung destruktiv zu kombinieren.

## Revendications

1. Système de conversion analogique-numérique Josephson (50) comprenant :
une ligne de commande (52) couplée inductivement à une ligne de signal d'entrée (58) sur laquelle un signal analogique d'entrée (I_{S}) est fourni, la ligne de signal d'entrée (58) étant couplée inductivement à la ligne de commande (52) pour propager un courant d'entrée induit (I_{IC}) qui est basé sur le signal analogique d'entrée (I_{S}), sur la ligne de commande (52) ;
au moins un étage de ligne de transmission Josephson JTL (64, 66) qui est polarisé via un courant de polarisation CC (I_{IDC1}, I_{IDC2}, I_{IDC3}) et est configuré pour générer au niveau d'une phase prédéterminée d'un signal d'horloge fourni à l'étage JTL (64, 66) une impulsion de sortie en réponse au courant d'entrée induit (I_{C}) et au courant de polarisation CC (I_{IDC1}, I_{IDC2}, I_{IDC3}) dépassant un courant de seuil prédéterminé associé à au moins un étage JTL ;
**caractérisé par le fait qu'**il comprend en outre :
une ligne de polarisation CC (60) couplée inductivement à la ligne de commande (52), la ligne de polarisation CC (60) étant configurée pour conduire un courant de réglage CC (I_{DC}) qui fournit inductivement ledit courant de polarisation CC (I_{IDC1}, I_{IDC2}, I_{IDC3}) sur la ligne de commande (52), la ligne de polarisation CC (60) étant couplée inductivement à la ligne de commande via un premier transformateur (54) et un troisième transformateur (62), le courant d'entrée induit (I_{DC}) étant fourni via un deuxième transformateur (56) agencé sur la ligne de commande (52) entre les premier et troisième transformateurs (54, 62).

2. Système selon la revendication 1, dans lequel le courant de polarisation CC induit présente une amplitude approximativement nulle au niveau d'un enroulement secondaire du deuxième transformateur.

3. Système selon la revendication 2, dans lequel le premier transformateur comprend un premier enroulement primaire configuré pour propager le courant de réglage continu et un premier enroulement secondaire configuré pour propager une première partie du courant de polarisation CC dans une première direction sur la ligne de commande, dans lequel le troisième transformateur comprend un second enroulement primaire configuré pour propager le courant d'accord CC et un second enroulement secondaire configuré pour propager une deuxième partie du courant de polarisation CC dans une seconde direction sur la ligne de commande et une troisième partie du courant de polarisation continu dans la première direction sur la ligne de commande, dans lequel la première partie et la deuxième partie du courant de polarisation CC sont approximativement égales.

4. Système selon la revendication 2, dans lequel les premier et troisième transformateurs ne sont pas égaux en ce qui concerne le couplage inductif du courant de réglage CC pour fournir le courant de polarisation CC induit à la ligne de commande.

5. Système selon la revendication 1, dans lequel l'au moins un étage JTL comprend un premier étage JTL et un second étage JTL qui sont agencés sur des extrémités opposées de la ligne de commande, dans lequel chacun des étages JTL est disposé sensiblement de la même manière.

6. Système selon la revendication 5, dans lequel le premier étage JTL comprend un premier dispositif d'interférence quantique supraconducteur SQUID couplé à un signal d'horloge et couplé à la ligne de commande, dans lequel le second étage JTL comprend un second SQUID couplé au signal d'horloge et interconnectant la ligne de commande et une sortie (14) sur laquelle l'impulsion de sortie est fournie en réponse au courant d'entrée induit et au courant de polarisation CC dépassant le courant de seuil prédéterminé associé aux premier et second étages JTL au niveau d'une phase prédéterminée du signal d'horloge.

7. Système selon la revendication 6, dans lequel le signal d'horloge est un signal d'horloge à logique quantique réciproque RQL.

8. Système selon la revendication 5, dans lequel chacun des premier et second étages JTL est couplé à un signal d'horloge, dans lequel le signal d'horloge est configuré pour polariser au moins une jonction Josephson associée à chacun des premier et second étages JTL au niveau d'une phase respective du signal d'horloge et pour se combiner de manière destructive au niveau de la ligne de commande.

9. Procédé (100) pour convertir un signal d'entrée analogique en une impulsion de sortie, le procédé comprenant :
la fourniture (102) du signal d'entrée analogique sur une ligne de signal d'entrée pour fournir inductivement un courant d'entrée induit sur une ligne de commande ;
la fourniture (104) d'un courant de réglage CC sur une ligne de polarisation CC qui est couplée inductivement à la ligne de commande via un premier transformateur et un troisième transformateur pour fournir inductivement un courant de polarisation CC sur la ligne de commande, dans lequel le courant de polarisation CC induit est fourni via un troisième transformateur agencé sur la ligne de commande entre le premier et le deuxième transformateurs ; et
la fourniture (106) d'un signal d'horloge à au moins un étage JTL de ligne de transmission Josephson qui est couplé à la ligne de commande pour générer l'impulsion de sortie sur une sortie de l'au moins un étage JTL au niveau d'une phase prédéterminée du signal d'horloge en réponse au courant d'entrée induit et au courant de polarisation CC dépassant un courant de seuil prédéterminé associé à l'au moins un étage JTL.

10. Procédé selon la revendication 9, dans lequel la fourniture du courant de réglage CC comprend en outre la fourniture inductive du courant de polarisation CC induit présentant une amplitude nulle au niveau d'un enroulement secondaire du deuxième transformateur.

11. Procédé selon la revendication 9, dans lequel la fourniture du signal d'horloge comprend la fourniture du signal d'horloge sous la forme d'un signal d'horloge à logique quantique réciproque RQL, dans lequel l'au moins un étage JTL comprend un premier étage JTL et un second étage JTL agencés sur des extrémités opposées de la ligne de commande, dans lequel le premier étage JTL comprend un premier dispositif d'interférence quantique supraconducteur SQUID couplé au signal d'horloge RQL et couplé à la ligne de commande, dans lequel le second étage JTL comprend un second SQUID couplé au signal d'horloge RQL et interconnectant la ligne de commande et la sortie.

12. Procédé selon la revendication 11, dans lequel la fourniture du signal d'horloge RQL comprend la fourniture du signal d'horloge RQL à chacun des premier et second étages JTL pour polariser au moins une jonction Josephson associée à chacun des premier et second étages JTL au niveau d'une phase respective du signal d'horloge RQL et pour se combiner de manière destructive au niveau de la ligne de commande.
